# EUROPÄISCHE PATENTSCHRIFT

(11) **EP 3 388 847 B1**
(45) Veröffentlichungstag und Bekanntmachung des Hinweises auf die Patenterteilung: **14.04.2021**
(21) Anmeldenummer: 18170981.7
(22) Anmeldetag: 09.05.2012
(51) Int. Cl.: G01R 23/18, G01R 13/02

(54) **SIGNALANALYSE IN ZEIT UND FREQUENZ**
SIGNAL ANALYSIS IN TIME AND FREQUENCY
ANALYSE DU SIGNAL AU NIVEAU DU TEMPS ET DE LA FRÉQUENCE

(30) Priorität: 11.05.2011 DE 102011075669
(43) Veröffentlichungstag der Anmeldung: 17.10.2018
(62) Teilanmeldung aus: 12720170.5
(73) Patentinhaber: Rohde & Schwarz GmbH & Co. KG, 81671 München (DE)
(72) Erfinder: Cirillo, Luke, 85586 Poing (DE)
(74) Vertreter: Körfer, Thomas

(56) Entgegenhaltungen:
- EP-A2- 2 418 497
- US-A1- 2005 261 847
- US-A1- 2008 259 082

## Beschreibung

Die Erfindung betrifft eine Vorrichtung und ein Verfahren zur Analyse von verschiedenen Signalen sowohl im Zeitbereich, als auch im Frequenzbereich.

Bei der Entwicklung von Kommunikationssystemen, beispielsweise von drahtlosen Kommunikationssystemen, ist es wichtig, dass diese innerhalb von vorgegebenen Standards arbeiten. Um Fehler innerhalb des Entwicklungsprozesses möglichst frühzeitig feststellen zu können, ist es wünschenswert, das von einem mobilen Kommunikationssystem erzeugte hochfrequente Kommunikationssignal analysieren zu können. Dadurch können Abweichungen innerhalb des hochfrequenten Kommunikationssignals von dem zugrundeliegenden Standard festgestellt werden. Um ein solches hochfrequentes Kommunikationssignal analysieren zu können, muss dieses zuvor mittels eines Signalanalysators, z.B. eines Oszilloskops digital aufgezeichnet werden.

Aus der EP 2 113 777 A1 sind ein Signalanalysator und ein Verfahren für diesen bekannt, um ein aufgezeichnetes hochfrequentes Kommunikationssignal analysieren zu können.

Das hochfrequente Kommunikationssignal wird in den Frequenzbereich transformiert, um sein Spektrum und sein Spektrogramm in einem Diagramm darzustellen. Nachteilig an der EP 2 113 777 A1 ist, dass in dem Spektrogramm und dem Verlauf des Spektrums nicht alle Fehler erkennbar sind Instrumente, die das Zeitdomäne-Signal, das Spektrum und das Spektrogramm auf einer Bildschirmeinheit gleichzeitig darstellen können, sind aus US2008/259082, US2005/261847 und EP2418497 bekannt.

Es ist daher die Aufgabe der erfindungsgemäßen Anordnung zur Signalanalyse und des erfindungsgemäßen Verfahrens zum Betreiben der Anordnung zur Signalanalyse, eine Lösung zu schaffen, um ein aufgezeichnetes hochfrequentes Kommunikationssignal derart aufzubereiten, dass etwaige Fehler innerhalb des hochfrequenten Kommunikationssignals, welche auf eine fehlerhafte Implementierung des zugrundeliegenden Standards oder eine fehlerhafte Hardware schließen lassen, mit einer möglichst hohen Wahrscheinlichkeit erkannt werden.

Die Aufgabe wird bezüglich der Anordnung zur Signalanalyse durch die Merkmale des Anspruchs 1 und bezüglich des Verfahrens zum Betreiben der Anordnung zur Signalanalyse durch die Merkmale des Anspruchs 8 gelöst. Der Anspruch 14 beinhaltet ein Computerprogramm mit Programmcode-Mittel, um sämtliche Verfahrensschritte ausführen zu können, wenn das Programm auf einem Computer oder einem digitalen Signalprozessor ausgeführt wird. Der Anspruch 15 enthält ein Computerprogramm-Produkt mit insbesondere auf einen maschinenlesbaren Träger gespeichertem Programmcode-Mittel, um alle Verfahrensschritte durchführen zu können, wenn das Programm auf einem Computer oder einem digitalen Signalprozessor ausgeführt wird. In den jeweiligen Unteransprüchen sind vorteilhafte Weiterbildungen der erfindungsgemäßen Anordnung zur Signalanalyse sowie des erfindungsgemäßen Verfahrens zum Betreiben der Anordnung zur Signalanalyse angegeben.

Die erfindungsgemäße Anordnung zur Signalanalyse weist zumindest eine zentrale Datenverarbeitungseinheit und eine mit der zumindest einen zentralen Datenverarbeitungseinheit verbundene Bildschirmeinheit auf. Die zentrale Datenverarbeitungseinheit berechnet aus einem digitalisierten Signal ein Spektrum und ein Spektrogramm. Die zumindest eine zentrale Datenverarbeitungseinheit ist dabei so ausgebildet, dass sie die Bildschirmeinheit derart ansteuert, dass das Spektrogramm des digitalisierten Signals, der Verlauf des Spektrums des digitalisierten Signals und der Verlauf des im Zeitbereich vorliegenden digitalisierten Signals gemeinsam auf der Bildschirmeinheit darstellbar sind.

Besonders vorteilhaft ist es, dass die Informationen, die das digitalisierte Signal beinhaltet, auf unterschiedliche Art und Weise möglichst vollständig und gemeinsam dargestellt werden. Dadurch, dass das digitalisierte Signal auf drei verschiedene Weisen darstellbar ist, können Störungen besonders gut festgestellt werden.

Das erfindungsgemäße Verfahren zum Betreiben der Anordnung zur Signalanalyse, die eine zentrale Datenverarbeitungseinheit und eine mit der zumindest einen zentralen Datenverarbeitungseinheit verbundene Bildschirmeinheit aufweist, umfasst mehrere Verfahrensschritte. In einem ersten Verfahrensschritt werden das Spektrum und das Spektrogramm aus einem digitalisierten Signal durch die zentrale Datenverarbeitungseinheit berechnet. In einem weiteren Verfahrensschritt wird das Spektrogramm des digitalisierten Signals, der Verlauf des Spektrums des digitalen Signals und der Verlauf des im Zeitbereich vorliegenden digitalisierten Signals gemeinsam auf der Bildschirmeinheit durch die zumindest eine zentrale Datenverarbeitungseinheit dargestellt. Besonders vorteilhaft ist, dass sowohl das Spektrogramm, als auch die Verläufe des digitalisierten Signals im Zeitbereich und im Frequenzbereich gemeinsam auf der Bildschirmeinheit dargestellt werden, was die Analyse des digitalisierten Signals erheblich erleichtert.

Die erfindungsgemäße Anordnung zur Signalanalyse umfasst weiter eine zentrale Datenverarbeitungseinheit, wodurch das digitalisierte Signal in einer Speichereinheit speicherbar ist. Wenn durch die zumindest eine zentrale Datenverarbeitungseinheit das digitalisierte Signal in den Frequenzbereich transformiert ist und in der Speichereinheit speicherbar ist, wird zum Beispiel sichergestellt, dass rechenintensive Schritte, wie das Transformieren des digitalisierten Signals in den Frequenzbereich nur einmal ausgeführt werden müssen.

Ein weiterer Vorteil der erfindungsgemäßen Anordnung zur Signalanalyse besteht, wenn ein Frequenz- und Zeitbereich innerhalb des Spektrogramms beliebig auswählbar ist und wenn durch die zumindest eine zentrale Datenverarbeitungseinheit für den ausgewählten Frequenz- und Zeitbereich der Verlauf des Spektrums und der zeitliche Verlauf des digitalisierten Signals aktualisierbar sind und auf der Bildschirmeinheit dargestellt sind und/oder wenn durch die zumindest eine zentrale Datenverarbeitungseinheit der im Spektrogramm ausgewählte Frequenzbereich in das zweite Diagramm einzeichenbar ist und/oder wenn durch die zumindest eine zentrale Datenverarbeitungseinheit der im Spektrogramm ausgewählte Zeitbereich in das dritte Diagramm einzeichenbar ist. Durch die Möglichkeit, dass innerhalb des Spektrogramms ein bestimmter Frequenz- und Zeitbereich auswählbar ist, wobei in Abhängigkeit von dem ausgewählten Frequenz- und Zeitbereich der Verlauf des Spektrums und der zeitliche Verlauf des digitalisierten Signals aktualisierbar ist, kann auf besonders vorteilhafte Weise das digitalisierte Signal näher analysiert werden. Besonders vorteilhaft ist dabei ebenfalls, dass der ausgewählte Frequenzbereich in den Verlauf des Spektrums und der ausgewählte Zeitbereich in den zeitlichen Verlauf des digitalisierten Signals einzeichenbar sind. Dies erleichtert die Zuordnung der einzelnen Signalanteile des digitalisierten Signals innerhalb des Spektrogramms zu den Verläufen in Frequenz- und Zeitbereich.

Weiter ist die erfindungsgemäße Anordnung zur Signalanalyse so ausgebildet, dass das im Zeitbereich vorliegende digitalisierte Signal durch einen Bandpass filterbar ist, wobei der Durchlassbereich des Bandpass dem ausgewählten Frequenzbereich des ersten Diagramms für das Spektrogramm oder dem ausgewählten Frequenzbereich des zweiten Diagramms für den Verlauf des Spektrums entspricht. Dadurch ist sichergestellt, dass nur diejenigen Signalanteile im Verlauf des Zeitbereichs des vorliegenden digitalisierten Signals innerhalb des dritten Diagramms auftauchen, die innerhalb des gewünschten Frequenzbereichs liegen.

Schlussendlich besteht ein Vorteil der erfindungsgemäßen Anordnung zur Signalanalyse, wenn der Teil des digitalisierten Signals, der innerhalb des ausgewählten Zeitbereichs und/oder Frequenzbereich liegt, durch die zumindest eine zentrale Datenverarbeitungseinheit an eine Auswerteeinheit übergebbar ist. Eine solche Auswerteeinheit kann beispielsweise den Teil des digitalisierten Signals, der die zu übertragenden Nutzdaten enthält, dahingehend auswerten, ob dieser Teil dem Aufbau des zugrundeliegenden Standards entspricht. Die Auswerteeinheit kann ebenfalls eine Modulationsanalyse beinhalten.

Ein weiterer Vorteil für das erfindungsgemäße Verfahren zum Betreiben der Anordnung zur Signalanalyse besteht, wenn ein beliebiger Frequenzbereich innerhalb des zweiten Diagramms für den Verlauf des Spektrums auswählbar ist und wenn in Abhängigkeit des ausgewählten Frequenzbereichs der zeitliche Verlauf des digitalisierten Signals durch die zumindest eine zentrale Datenverarbeitungseinheit aktualisierbar ist und/oder wenn der ausgewählte Frequenzbereich in das erste Diagramm für das Spektrogramm durch die zumindest eine zentrale Datenverarbeitungseinheit eingezeichnet wird. Dies erlaubt, dass die interessanten Bereiche innerhalb des Verlaufs des Spektrums auch in dem Spektrogramm und in dem zeitlichen Verlauf für das digitalisierte Signal hervorgehoben werden können.

Weiterhin besteht bei dem erfindungsgemäßen Verfahren zum Betreiben der Anordnung zur Signalanalyse ein Vorteil, wenn ein Zeitbereich innerhalb des dritten Diagramms für den zeitlichen Verlauf des digitalisierten Signals beliebig ausgewählt wird und wenn in Abhängigkeit des ausgewählten Zeitbereichs der Verlauf des Spektrums aktualisiert wird und/oder wenn der ausgewählte Zeitbereich in das Diagramm für das Spektrogramm durch die zumindest eine zentrale Datenverarbeitungseinheit eingezeichnet wird. Dies erlaubt, dass interessante Teile des digitalisierten Signals, die im zeitlichen Verlauf des digitalisierten Signals ausgewählt werden, in den anderen beiden Diagrammen ebenfalls deutlicher dargestellt werden.

Schlussendlich besteht bei dem erfindungsgemäßen Verfahren zum Betreiben der Anordnung zur Signalanalyse ein Vorteil, wenn das gefilterte digitalisierte Signal in seiner Auflösung durch eine erste Detektoreinheit dezimiert wird, sodass das dezimierte digitalisierte Signal einer Auflösung der Bildschirmeinheit entspricht, wobei durch die erste Detektoreinheit entweder der Mittelwert oder der quadratische Mittelwert oder der Maximalwert oder der Minimalwert oder der Auto-Peak-Wert (dt. automatischer Spitzenwert) von zumindest zwei Werten des digitalisierten Signals berechnet wird und/oder wenn das in den Frequenzbereich transformierte digitalisierte Signal in seiner Auflösung durch eine zweite Detektoreinheit dezimiert wird, sodass das dezimierte digitalisierte Signal einer Auflösung der Bildschirmeinheit entspricht, wobei durch die zweite Detektoreinheit entweder der Mittelwert oder der quadratische Mittelwert oder der Maximalwert oder der Minimalwert oder der Auto-Peak-Wert von zumindest zwei Werten des digitalisierten Signals berechnet wird. Die verschiedenen Möglichkeiten, mit der die erste und die zweite Detektoreinheit betrieben werden können, erlauben, dass auch zeitlich sehr kurze Störungen auf der Bildschirmeinheit darstellbar sind.

Verschiedene Ausführungsbeispiele der Erfindung werden nachfolgend unter Bezugnahme auf die Zeichnung beispielhaft beschrieben. Gleiche Gegenstände weisen dieselben Bezugszeichen auf. Die entsprechenden Figuren der Zeichnung zeigen im Einzelnen:
- Fig. 1: ein Ausführungsbeispiel eines Blockschaltbilds, das den Aufbau der erfindungsgemäßen Anordnung zur Signalanalyse zeigt;
- Fig. 2: ein weiteres Ausführungsbeispiel eines Blockschaltbilds der Erfindung, das die Funktionsweise der zentralen Datenverarbeitungseinheit innerhalb der Anordnung zur Signalanalyse näher beschreibt;
- Fig. 3: ein Ausführungsbeispiel, das die Funktionsweise der erfindungsgemäßen Anordnung zur Signalanalyse nach dem Laden eines zu analysierenden Signals näher beschreibt;
- Fig. 4: ein weiteres Ausführungsbeispiel, das die Funktionsweise der erfindungsgemäßen Anordnung zur Signalanalyse nach dem Laden eines zu analysierenden Signals näher beschreibt;
- Fig. 5A: ein Ausführungsbeispiel, das die Funktionsweise der erfindungsgemäßen Anordnung zur Signalanalyse zum Analysieren von Störungen innerhalb eines geladenen Signals näher beschreibt;
- Fig. 5B: ein weiteres Ausführungsbeispiel, das die Funktionsweise der erfindungsgemäßen Anordnung zur Signalanalyse zum Analysieren von Störungen innerhalb eines geladenen Signals näher beschreibt;
- Fig. 6: ein Ausführungsbeispiel eines Flussdiagramms, das die Funktionsweise der erfindungsgemäßen Anordnung zur Signalanalyse näher beschreibt; und
- Fig. 7: ein weiteres Ausführungsbeispiel eines Flussdiagramms, das die Funktionsweise der erfindungsgemäßen Anordnung zur Signalanalyse näher beschreibt.

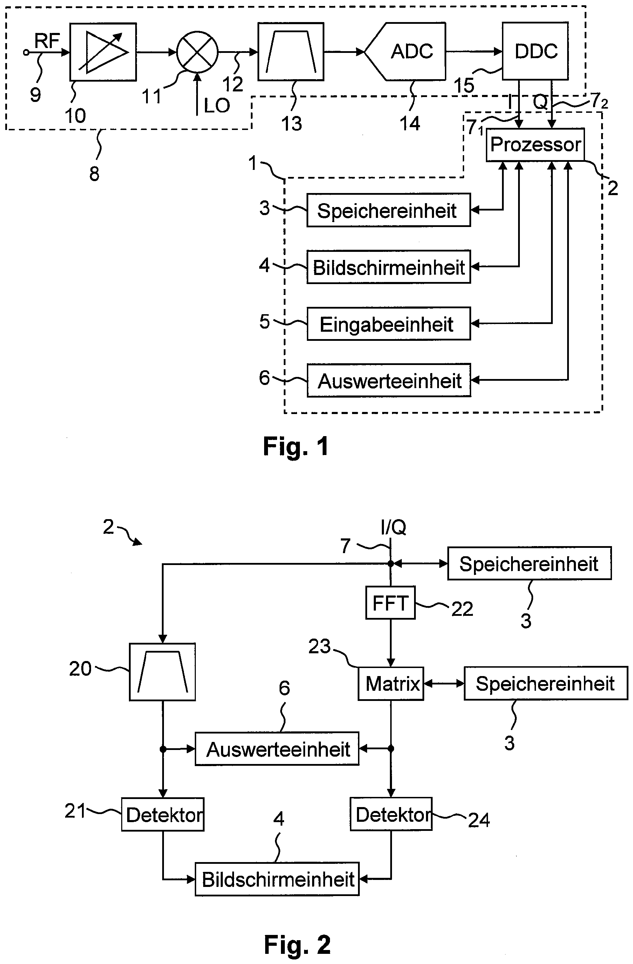

Fig. 1 zeigt ein Ausführungsbeispiel eines Blockschaltbilds, das den Aufbau der erfindungsgemäßen Anordnung 1 zur Signalanalyse zeigt. Die Anordnung 1 zur Signalanalyse umfasst dabei zumindest eine zentrale Datenverarbeitungseinheit 2. Die zumindest eine zentrale Datenverarbeitungseinheit 2 kann einen oder mehrere Prozessoren und/oder FPGAS (engl. field programmable gate array; dt. im (Anwendungs-) Feld- programmierbare (Logik-) Gatter-Anordnung) und/oder DSPs (engl. digital signal processor; dt. digitaler Signalprozessor) aufweisen. Mit der zumindest einen zentralen Datenverarbeitungseinheit 2 sind zumindest eine Speichereinheit 3, eine Bildschirmeinheit 4, eine Eingabeeinheit 5 und eine Auswerteeinheit 6 verbunden.

Bei der zumindest einen Speichereinheit 3 kann es sich beispielsweise um einen Arbeitsspeicher und/oder einen Festplattenspeicher handeln, der innerhalb der Anordnung 1 zur Signalanalyse ausgebildet ist und/oder mit der Anordnung 1 zur Signalanalyse über beispielsweise eine Netzwerkschnittstelle verbunden ist.

Bei der Bildschirmeinheit 4 handelt es sich bevorzugt um eine Bildschirmeinheit 4 mit einem berührungsempfindlichen Bildschirm. Bevorzugt werden dabei solche berührungsempfindlichen Bildschirme eingesetzt, die über einen resistiven oder kapazitiven oder induktiven Berührungsbildschirm verfügen.

Die Eingabeeinheit 5 umfasst sämtliche mit der Anordnung 1 zur Signalanalyse verbundene Knöpfe und/oder Taster sowie weitere Eingabeelemente, wie beispielsweise eine Tastatur oder eine Maus. Sämtliche von der Eingabeeinheit 5 erfassten Eingaben werden an die zumindest eine zentrale Datenverarbeitungseinheit 2 weitergeleitet.

Die mit der zumindest einen zentralen Datenverarbeitungseinheit 2 verbundene Auswerteeinheit 6 empfängt, wie später noch ausführlich erläutert wird, ausgewählte Anteile des digitalisierten Signals 7₁, 7₂ zu dessen weiterer Verarbeitung. Bei der Auswerteeinheit 6 kann es sich beispielsweise um GSM- Messeinheiten (engl. global system for mobile communication; dt. weltweites System zur mobilen Kommunikation) oder um UMTS-Messeinheiten (engl. universal mobile telecommunication system; dt. universelles mobile Telekommunikationssystem) handeln. Eine solche Auswerteeinheit 6 kann ebenfalls eine Modulationsanalyse beinhalten.

Der Anordnung 1 zur Signalanalyse wird ein gemessenes digitalisiertes Signal 7₁, 7₂ übergeben. Ein solches digitalisiertes Signal 7₁, 7₂ kann beispielsweise mit einem Signalanalysator 8 oder einem Oszilloskop aufgezeichnet werden. In Fig. 1 ist hierzu ein vereinfachtes Blockschaltbild eines Signalanalysators 8 dargestellt. Ein zu analysierendes hochfrequentes Kommunikationssignal 9 wird durch einen Verstärker 10 in seiner Amplitude verstärkt. Anschließend wird das verstärkte hochfrequente Kommunikationssignal 9 über einen Mischer 11 mittels des lokalen Oszillatorsignals auf eine Zwischenfrequenz 12 heruntergemischt. Das auf eine Zwischenfrequenz 12 heruntergemischte hochfrequente Kommunikationssignal 9 wird anschließend durch einen Bandpass 13 gefiltert, bevor es durch einen Analog/Digital-Umsetzer 14 digitalisiert wird. Über einen digitalen Abwärtswandler 15 (engl. digital down converter) wird das digitalisierte Hochfrequenzsignal in das Basisband heruntergemischt, wobei in dem dargestellten Ausführungsbeispiel der digitale Abwärtswandler 15 einen Inphase-Anteil 7₁ (dt. gleichphasig) und einen Quadratur-Anteil 7₂ des digitalisierten Signals 7 ausgibt. Der Inphase-Anteil 7₁ und der Quadratur-Anteil 7₂ des digitalisierten Signals 7 des Signalanalysators 8 wird an die zumindest eine zentrale Datenverarbeitungseinheit 2 der Anordnung 1 zur Signalanalyse übergeben.

Nicht dargestellt ist in Fig. 1 ein Triggersignal (dt. Auslösesignal), welches dem Analog/Digital-Umsetzer 14 zugeführt wird, sodass nur die Teile des hochfrequenten Kommunikationssignals 9 digitalisiert werden, bei denen die Triggerbedingung erfüllt ist.

Fig. 2 zeigt ein weiteres Ausführungsbeispiel eines Blockschaltbilds der Erfindung, das die Funktionsweise der zentralen Datenverarbeitungseinheit 2 innerhalb der Anordnung 1 zur Signalanalyse näher beschreibt. Zu Beginn wird das digitalisierte Signal 7 an die zumindest eine zentrale Datenverarbeitungseinheit 2 innerhalb der Anordnung 1 zur Signalanalyse übergeben. Das digitalisierte Signal 7 wird durch die zumindest eine zentrale Datenverarbeitungseinheit 2 in einer Speichereinheit 3 gespeichert.

Das digitalisierte Signal 7 wird im Anschluss daran durch einen Bandpass 20 gefiltert. Der Durchlassbereich des Bandpass 20 ist dabei, wie später noch erläutert wird, einstellbar. Das gefilterte digitalisierte Signal 7 kann dann durch die zumindest eine zentrale Datenverarbeitungseinheit 2 an eine Auswerteeinheit 6 übergeben werden.

Das gefilterte digitalisierte Signal 7 wird ebenfalls weiterhin an eine erste Detektoreinheit 21 übergeben. Innerhalb der ersten Detektoreinheit 21 wird das gefilterte digitalisierte Signal 7 in seiner Auflösung dezimiert, sodass das dezimierte gefilterte digitalisierte Signal 7 einer Auflösung der Bildschirmeinheit 4 entspricht. Die erste Detektoreinheit 21 berechnet von zumindest 2 Werten des gefilterten digitalisierten Signals 7 entweder den Mittelwert oder den quadratischen Mittelwert oder den Maximalwert oder den Auto-Peak-Wert. Für den Fall, dass die Bildschirmeinheit 4 beispielsweise eine horizontale Auflösung von 1000 Punkten aufweist und für den Fall, dass das gefilterte digitalisierte Signal 7 beispielsweise 10000 Messpunkte beinhaltet, berechnet die erste Detektoreinheit 21 von zehn aufeinanderfolgenden Messwerten des gefilterten digitalisierten Signals 7 den Mittelwert oder den quadratischen Mittelwert oder den Maximalwert oder den Minimalwert oder den Auto-Peak-Wert.

Unter einem Auto-Peak-Wert ist zu verstehen, dass sowohl der Maximalwert, als auch der Minimalwert von einem Intervall, in diesem Fall von 10 Messwerten, berücksichtigt wird. Werden, wie in dem oben genannten Beispiel zehn Messwerte zusammengefasst und besitzt der Größte dieser zehn Messwerte den Wert 50 und der Kleinste dieser zehn Messwerte den Wert 10, so werden an der entsprechenden vertikalen Zeile der Bildschirmeinheit 4 sowohl der Messwert 50, als auch der Messwert 10 eingezeichnet und gegebenenfalls mit einer Linie miteinander verbunden. Die Art und Weise, wie die erste Detektoreinheit 21 arbeiten soll, kann beliebig über eine Eingabeeinheit 5 eingestellt werden. Dadurch ist sichergestellt, dass auch kleinste Störungen innerhalb des gefilterten digitalisierten Signals 7 erkennbar sind und zur Anzeige gebracht werden können.

Weiterhin wird das digitalisierte Signal 7, welches durch die zumindest eine Datenverarbeitungseinheit 2 in der Speichereinheit 3 gespeichert ist, in den Frequenzbereich transformiert. Dies geschieht bevorzugt mittels einer Fast-Fourier-Transformation (dt. schnelle Fourier-Transformation) in dem FFT-Block 22. Diese Fourier-Transformation wird bevorzugt auf speziell hierfür ausgelegten Co-Prozessoren ausgeführt, die beispielsweise innerhalb eines digitalen Signalprozessors ausgebildet sein können. Um das gesamte digitalisierte Signal 7 in den Frequenzbereich zu transformieren sind meistens mehrere Fourier-Transformationen nötig. Das in den Frequenzbereich transformierte digitalisierte Signal 7 wird bevorzugt in einer Matrix 23 gespeichert. Die Spalten dieser Matrix 23 stellen dabei bevorzugt den Frequenzbereich dar, wohingegen die Zeilen der Matrix 23 den Zeitbereich darstellen. Die Matrix 23 bildet damit das Spektrogramm 30 für das in den Frequenzbereich transformierte digitalisierte Signal 7. Die Art und Weise, wie die Ergebnisse der einzelnen Fourier-Transformationen zu dieser Matrix 23 zusammengefasst werden können, kann beispielsweise mit dem Verfahren von Welsh (Welsh-Periodogram) erfolgen.

Dieses Spektrogramm wird durch die zumindest eine zentrale Datenverarbeitungseinheit 2 in der Speichereinheit 3 abgespeichert. Das Spektrogramm kann im Weiteren, wie später noch erläutert wird, ganz oder in Teilen an die Auswerteeinheit 6 übergeben werden.

Außerdem kann das in der Matrix 23 gespeicherte Spektrogramm des digitalisierten Signals 7 an eine zweite Detektoreinheit 24 übergeben werden. Die zweite Detektoreinheit 24 dezimiert das in den Frequenzbereich transformierte digitalisierte Signal 7 in seiner Auflösung derart, dass das dezimierte digitalisierte Signal 7 einer Auflösung der Bildschirmeinheit 4 entspricht. Die zweite Detektoreinheit 24 berechnet dabei von zumindest zwei Werten des in den Frequenzbereich transformierten digitalisierten Signals 7 entweder den Mittelwert oder den quadratischen Mittelwert oder den Maximalwert oder den Minimalwert oder den Auto-Peak-Wert. Für den Fall, dass die Bildschirmeinheit 4 eine Auflösung in der horizontalen Achse von beispielsweise 1000 Bildpunkten besitzt und die Matrix 23, die das Spektrogramm des digitalisierten Signals 7 beinhaltet, beispielsweise 10000 Spalten mit Messwerten aufweist, so fasst die zweite Detektoreinheit 24 je zehn Messwerte mit den genannten Dezimationsmethoden zu einem neuen dezimierten Messwert zusammen. Selbiges gilt auch für die vertikale Achse der Bildschirmeinheit 4. Für den Fall, dass die vertikale Achse der Bildschirmeinheit 4 beispielsweise ebenfalls 1000 Bildpunkte aufweist und die Matrix 23 ebenfalls 10000 Zeileneinträge mit Messwerten besitzt, berechnet die zweite Detektoreinheit 24 aus den Messwerten von jeweils 10 Zeilen je einen neuen dezimierten Messwert.

Die zweite Detektoreinheit 24 dient ebenfalls dazu, den Verlauf des Spektrums für das in den Frequenzbereich transformierte digitalisierte Signal 7 zu berechnen und an die Bildschirmeinheit 4 zu übergeben. Um einen Verlauf des Spektrums für das in den Frequenzbereich transformierte digitalisierte Signal 7 zu erhalten, dezimiert die zweite Detektoreinheit 24 das Spektrogramm in der Art, dass nur eine bestimmt Anzahl an Zeilen, die auswählbar sind, mittels der beschriebenen Dezimations-Modi dezimiert werden. Dieser Sachverhalt wird im Weiteren noch ausführlich thematisiert.

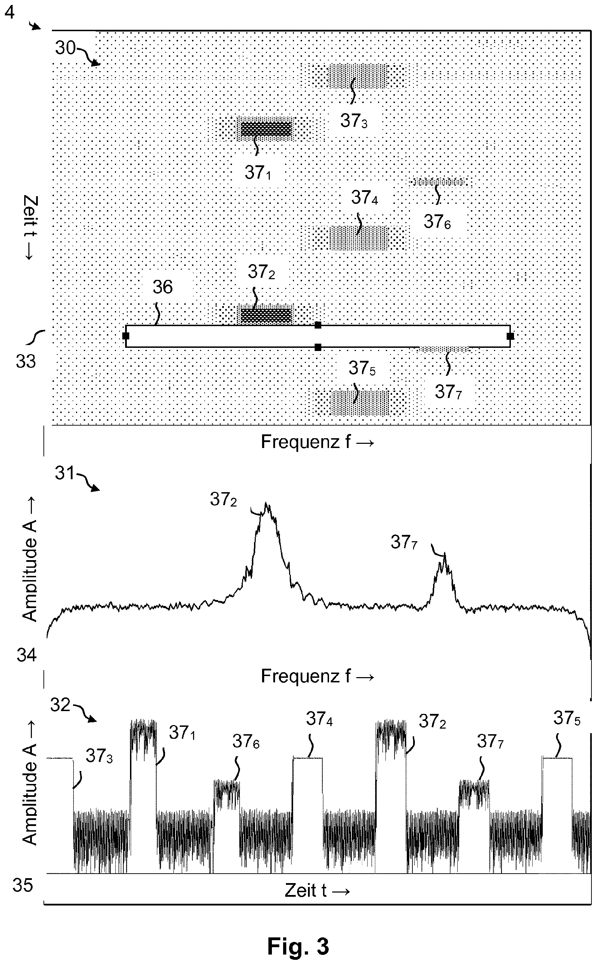

Fig. 3 zeigt ein Ausführungsbeispiel, das die Funktionsweise der erfindungsgemäßen Anordnung 1 zur Signalanalyse nach dem Laden eines zu analysierenden Signals 7 näher beschreibt. Fig. 3 zeigt eine Möglichkeit, wie das Spektrogramm 30 des digitalisierten Signals 7, der Verlauf des Spektrums 31 des digitalisierten Signals 7 und der Verlauf 32 des im Zeitbereich vorliegenden digitalisierten Signals 7 gemeinsam und zur selben Zeit auf der Bildschirmeinheit 4 darstellbar sind. In Fig. 3 sind dabei drei Diagramme 33, 34, 35 dargestellt, in die das zu analysierende Signal 7 auf unterschiedliche Art und Weise eingezeichnet ist.

In einem ersten Diagramm 33 ist das Spektrogramm 30 des dezimierten und in den Frequenzbereich transformierten digitalisierten Signals 7 eingezeichnet. Auf der horizontalen Achse des ersten Diagramms 33 ist die Frequenz in die rechte Richtung zunehmend aufgetragen. Auf der vertikalen Achse des ersten Diagramms 33 ist die Zeit t aufgetragen, die nach unten hin zunimmt. Schraffiert dargestellt ist die Amplitude, beziehungsweise die Energie der einzelnen Signalanteile bei einer bestimmten Frequenz und zu einer bestimmten Zeit. Je dunkler die Schraffur ist, desto höher ist die Amplitude, beziehungsweise die Signalenergie. Bevorzugt würde diese Information auf einer Bildschirmeinheit 4 durch eine unterschiedliche Farbwahl dargestellt werden. Je heller der Farbton, desto höher dabei die Signalenergie. Zu erkennen ist in dem ersten Diagramm 33 ebenfalls, dass es sieben Signalimpulse 37₁, 37₂, 37₃, 37₄, 37₅, 37₆ und 37₇ gibt, die zeitlich voneinander beabstandet ausgesendet sind, wobei drei 37₃, 37₄, 37₅ dieser Signalimpulse 37₁ bis 37₇ auf einer ersten Frequenz übertragen werden, zwei 37₁, 37₂ dieser Signalimpulse 37₁ bis 37₇ auf einer zweiten Frequenz übertragen werden und zwei 37₆, 37₇ dieser Signalimpulse 37₁ bis 37₇ auf einer dritten Frequenz übertragen werden. Die Signalenergie der Signalimpulse 37₁, 37₂, ist am höchsten, gefolgt von den Signalimpulsen 37₃, 37₄, 37₄ und den Signalimpulsen 37₆, 37₇.

Bei diesem, im ersten Diagramm 33 dargestellten digitalisieren Signal 7, handelt es sich um ein Multiband GSM-Signal mit verschiedenen Frames (dt. Rahmen) in denen verschiedene Slots (dt. Schlitze) aktiv sind.

Ebenfalls ist in dem ersten Diagramm 33 ein Auswahlbereich 36 eingezeichnet. Dieser Auswahlbereich 36 kann in seiner Größe (Frequenz und Zeit), wie später noch erläutert wird, beliebig angepasst werden. Das digitalisierte Signal 7, dessen Spektrum 30 über der Zeit in dem ersten Diagramm 33 in Fig. 3 dargestellt ist, weist wie beschrieben insgesamt sieben Signalimpulse 37₁, 37₂, 37₃, 37₄, 37₅, 37₆, 37₇ auf, deren Signalenergie und deren Zeit und Frequenz auf welcher sie auftreten, sich zum Teil unterscheiden. Zu erkennen ist, dass ein Teil der Signalimpulse 37₂ und 37₇ innerhalb des Auswahlbereichs 36 liegt.

Außerdem sind in dem ersten Diagramm 33 noch weitere schmalbandige Störungen vorhanden, die sich durch eine unterschiedliche Schraffur und damit durch eine unterschiedliche Signalenergie zeigen.

In dem zweiten Diagramm 34 aus Fig. 3 ist der Verlauf des Spektrums 31 des digitalisierten Signals 7 dargestellt. Auf der horizontalen Achse ist, wie bei dem Spektrogramm 30 aus dem ersten Diagramm 33, ebenfalls die Frequenz f aufgetragen. Auf der vertikalen Achse des zweiten Diagramms 34 ist die Amplitude A, beziehungsweise die Signalenergie aufgetragen. Zu erkennen ist, dass in dem Verlauf des Spektrums 31 des digitalisierten Signals 7 verschieden hohe Signalamplituden vorliegen. In dem zweiten Diagramm 34 sind dabei zwei Signalspitzen zu erkennen. Die erste Signalspitze korrespondiert dabei mit dem Signalimpuls 37₂ und die zweite Signalspitze korrespondiert zu dem Signalimpuls 37₇. Bei den im zweiten Diagramm 34 dargestellten Signalimpulsen 37₂, 37₇ handelt es sich um die Signalimpulse 37₂, 37₇, die in dem ersten Diagramm 33 teilweise innerhalb des Auswahlbereichs 36 liegen.

Die zweite Detektoreinheit 24 dezimiert nach einem einstellbaren oder voreingestellten Dezimations-Modus die Amplitudenwerte über den ausgewählten Zeitbereich innerhalb des Auswahlbereichs 36 und stellt diese dezimierten Werte in dem zweiten Diagramm 34 dar. Würde der Auswahlbereich 36 aus dem ersten Diagramm 33 ein klein wenig nach unten verschoben werden, so würde der Signalimpuls 37₂ nicht mehr in dem zweiten Diagramm 34 dargestellt werden, wohingegen jedoch der Signalimpuls 37₇ in seiner Amplitude je nach eingestelltem Dezimations-Modus zunehmen würde. Dies gilt insbesondere für die Dezimations-Modi Mittelwert und quadratischer Mittelwert. In dem dritten Diagramm 35 aus Fig. 3 wird der zeitliche Verlauf 32 des digitalisierten Signals 7 dargestellt. Auf der horizontalen Achse ist die Zeit t aufgetragen, wohingegen auf der vertikalen Achse die Amplitude A, beziehungsweise die Signalenergie aufgetragen ist. Zu erkennen sind sieben Signalimpulse 37₁, 37₂, 37₃, 37₄, 37₅, 37₆, 37₇, die zu den Signalimpulsen 37₁, 37₂, 37₃, 37₄, 37₅, 37₆, 37₇ aus dem ersten Diagramm 33 korrespondieren. Der Durchlassbereich des Bandpass 20 aus Fig. 2 ist derart eingestellt, dass er dem durch den Auswahlbereich 36 im ersten Diagramm 33 ausgewählten Frequenzbereich entspricht. Durch Verändern der Lage oder der Größe des Auswahlbereichs 36 können folglich unerwünschte Störungen aus dem dritten Diagramm 35 herausgefiltert werden.

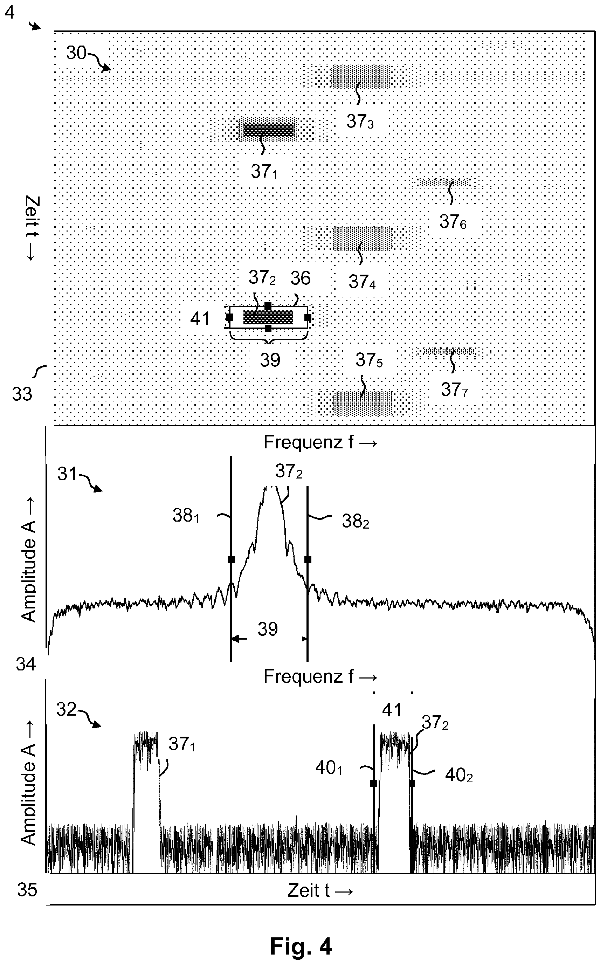

Fig. 4 zeigt ein weiteres Ausführungsbeispiel, dass die Funktionsweise der erfindungsgemäßen Anordnung 1 zur Signalanalyse nach dem Laden eines zu analysierenden Signals 7 näher beschreibt. Zu erkennen sind ebenfalls wieder die drei Diagramme 33, 34, 35 die auf der Bildschirmeinheit 4 dargestellt werden. In dem ersten Diagramm 33 sind ebenfalls die sieben Signalimpulse 37₁ bis 37₇ dargestellt. Der Auswahlbereich 36 ist dagegen derart eingestellt, dass er in seinem Zeitbereich und seinem Frequenzbereich in etwa deckungsgleich mit dem Signalimpuls 37₂ ist. Der Auswahlbereich 36 kann einerseits über die Eingabeeinheit 5 eingestellt werden und andererseits über eine automatische Erkennung der Signalamplitude durch die zumindest eine zentrale Datenverarbeitungseinheit 2, wobei diese mit einem zuvor festgelegten Schwellwert verglichen wird.

Das zweite Diagramm 34 aus Fig. 4 zeigt den Verlauf des Spektrums 31 des digitalisierten Signals 7. Zu erkennen ist dabei der Signalimpuls 37₂ innerhalb des zweiten Diagramms 34, welcher sich an derselben Stelle befindet, wie der Signalimpuls 37₂ innerhalb des ersten Diagramms 33. Eingezeichnet sind in das zweite Diagramm 34 ebenfalls zwei vertikale Begrenzungslinien 38₁, 38₂, deren Abstand zueinander den gleichen Frequenzbereich 39 umfasst, wie der Auswahlbereich 36 aus dem ersten Diagramm 33.

In dem dritten Diagramm 35 ist der zeitliche Verlauf 32 des digitalisierten Signals 7 dargestellt. Dabei ist der Durchlassbereich des Bandpass 20 aus Fig. 2 derart eingestellt, dass dieser in etwa so breit ist, wie der Frequenzbereich 39. Zu erkennen sind ebenfalls die beiden Signalimpulse 37₁ und 37₂. Dargestellt sind ebenfalls zwei vertikale Begrenzungslinien 40₁, 40₂, deren Abstand zueinander dem Zeitbereich 41 entspricht, wie er auch durch den Auswahlbereich 36 im ersten Diagramm 33 festgelegt ist.

Sobald der Auswahlbereich 36 aus dem ersten Diagramm 33 in seiner Größe verändert wird, werden die vertikalen Begrenzungslinien 38₁, 38₂ und 40₁, 40₂ automatisch in ihrem Abstand zueinander durch die zumindest eine zentrale Datenverarbeitungseinheit angepasst. Dabei wird auch gleichzeitig der Verlauf des Spektrums 31 und der zeitliche Verlauf 32 des digitalisierten Signals 7 angepasst.

Es ist ebenfalls möglich, dass die vertikalen Begrenzungslinien 38₁, 38₂ und 40₁, 40₂ über die Eingabeeinheit 5 in ihrem Abstand zueinander und in ihrer absoluten Position in den Diagrammen 34 und 35 veränderbar sind. Sobald eine der vertikalen Begrenzungslinien 38₁, 38₂ und/oder 40₁, 40₂ verändert wird, aktualisiert die zumindest eine zentrale Datenverarbeitungseinheit 2 den Auswahlbereich 36 in dem ersten Diagramm 33. Gleichzeitig ändert sich auch der Verlauf des Spektrums 31 und des im Zeitbereich vorliegenden digitalisierten Signals 7. Dies hängt damit zusammen, dass bei Verändern einer der vertikalen Begrenzungslinien 38₁, 38₂ und/oder 40₁, 40₂ der Bandpass 20 und die erste Detektionseinheit 21 und/oder die zweite Detektionseinheit 24 in ihrer Arbeitsweise angepasst werden. Dabei bleibt festzuhalten, dass die zumindest eine zentrale Datenverarbeitungseinheit 2 die Bildschirmeinheit 4 derart ansteuert, dass das Spektrogramm 30, der Verlauf des Spektrums 31 und der Verlauf 32 des digitalisierten Signals 7 im Zeitbereich gemeinsam und vor allen Dingen gleichzeitig auf der Bildschirmeinheit 4 dargestellt werden.

Sobald der Auswahlbereich 36 den Signalimpuls 37₂ optimal umfasst, kann der Teil des digitalisierten Signals 7 an eine Auswerteeinheit 6 übergeben werden, der innerhalb des Auswahlbereichs 36 liegt. Die Auswerteeinheit 6 kann ebenfalls eine Modulationsanalyse beinhalten. Wie in Fig. 2 dargestellt, wird dabei allerdings nicht das dezimierte digitalisierte Signal 7 an die Auswerteeinheit 6 übergeben, sondern das noch nicht in seiner Auflösung reduzierte digitalisierte Signal 7.

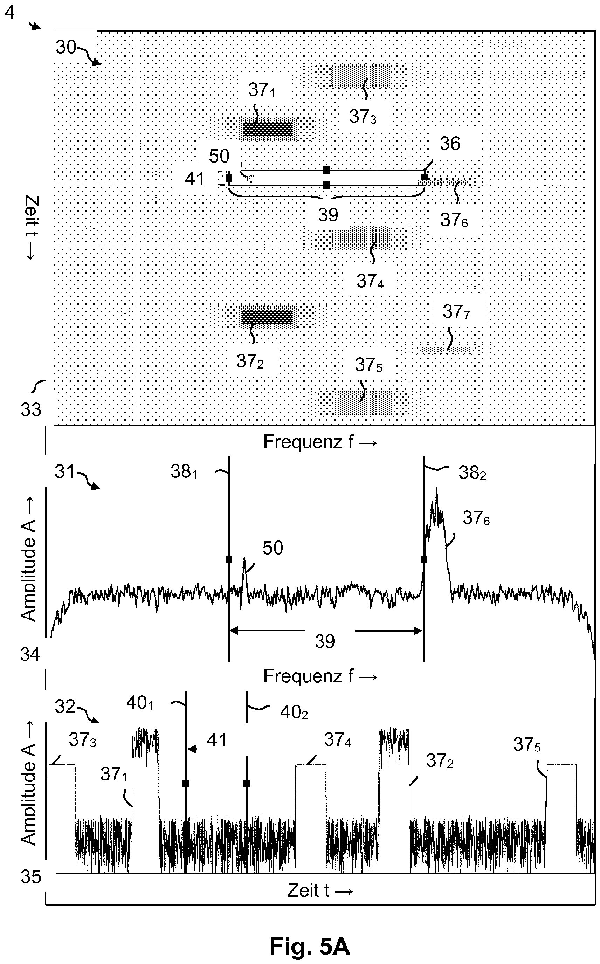

Fig. 5A zeigt ein Ausführungsbeispiel, dass die Funktionsweise der erfindungsgemäßen Anordnung 1 zur Signalanalyse zum Analysieren von Störungen 50 innerhalb eines geladenen Signals 7 näher beschreibt. Zu erkennen sind ebenfalls die drei Diagramme 33, 34, 35, die gemeinsam auf der Bildschirmeinheit 4 dargestellt sind, und gleichzeitig das digitalisierte Signal 7 in unterschiedlicher Art und Weise darstellen. Dargestellt ist ebenfalls der Auswahlbereich 36, der über das Spektrogramm 30 bewegt wird. In der Darstellung aus Fig. 5A liegt ein Teil des Signalimpulses 37₆ innerhalb des Auswahlbereichs 36. In dem ersten Diagramm ist ebenfalls zu erkennen, dass eine kleine Störung 50 ebenfalls innerhalb des Auswahlbereichs 36 liegt. Der Bandpass 20 und die erste und zweite Detektoreinheit 21, 24 sind entsprechend dem Auswahlbereich 36 angepasst. In dem zweiten Diagramm 34 ist zu erkennen, dass die vertikalen Begrenzungslinien 38₁, 38₂ in ihrem Abstand zueinander den gleiche Frequenzbereich 39 umfassen, wie der Auswahlbereich 36. Der Signalimpuls 37₆ liegt zu einem gewissen Teil noch innerhalb der vertikalen Begrenzungslinien 38₁ und 38₂. Ebenfalls ist sehr deutlich zu erkennen, dass eine Störung 50 (engl. spur) innerhalb des Auswahlbereichs 36 auftritt.

In dem dritten Diagramm 35 aus Fig. 5A sind ebenfalls die verschiedenen Signalimpulse 37₁, 37₂, 37₃, 37₄, 37₅ zu erkennen, die durch den Bandpass 20 nicht herausgefiltert sind. Die Signalimpulse 37₆, 37₇ sind allerdings herausgefiltert. Ebenfalls sind die vertikalen Begrenzungslinien 40₁, 40₂ dargestellt. Die Störung 50 ist in diesem Diagramm auf Grund des breiten Durchlassbereichs des Bandpass 20 nicht sichtbar. Bei Wahl eines anderen Dezimations-Modus kann diese Störung 50 aber im dritten Diagramm 35 angezeigt werden.

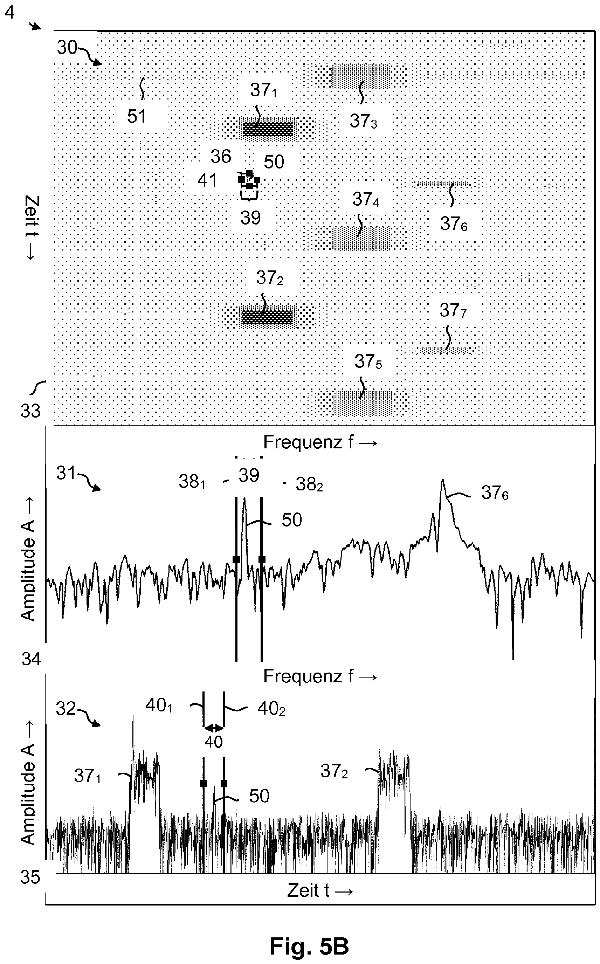

Fig. 5B zeigt ein weiteres Ausführungsbeispiel, dass die Funktionsweise der erfindungsgemäßen Anordnung 1 zur Signalanalyse zum Analysieren von Störungen 50 innerhalb eines geladenen Signals 7 näher beschreibt. In dem ersten Diagramm 33 ist zu erkennen, dass der Auswahlbereich 36 derart eingestellt ist, dass er die Störung 50 möglichst genau umgibt. Dies kann, wie bereits beschrieben wurde, dadurch geschehen, dass der Auswahlbereich 36 in dem ersten Diagramm 33 grob auf die Störung 50 eingestellt wird, um im Weiteren in dem zweiten Diagramm 34 und in dem dritten Diagramm 35 die vertikalen Begrenzungslinien 38₁, 38₂ und 40₁, 40₂ möglichst nahe an die Störung 50 zu schieben. Zu erkennen ist in dem ersten Diagramm 33 noch eine breitbandige Störung 51. Auf diese wird im Weiteren allerdings nicht gesondert eingegangen.

Gut zu erkennen ist im zweiten Diagramm 34 ebenfalls, dass die vertikalen Begrenzungslinien 38₁ und 38₂ die Störung 50 möglichst genau umschließen. Zu erkennen ist dabei ebenfalls noch der Verlauf des Spektrums 31 innerhalb dieses Bereichs mit dem Signalimpuls 37₆. Auch im dritten Diagramm 35 sind die vertikalen Begrenzungslinien 40₁ und 40₂ derart eingestellt, dass sie die Störung 50 möglichst genau umgeben. Der Verlauf 32 des im Zeitbereich vorliegenden digitalisierten Signals 7 ist mit seinen beiden Signalimpulsen 37₁ und 37₂ ebenfalls sehr gut erkennbar.

Im Weiteren kann der Inhalt des Auswahlbereichs 36 durch die zumindest eine zentrale Datenverarbeitungseinheit 2 an die Auswerteeinheit 6 übergeben werden, um genauere Rückschlüsse auf die Art der Störung 50 zu erlangen. Dabei wird, wie bereits erwähnt, das undezimierte digitalisierte Signal 7 an die Auswerteeinheit 6 übergeben.

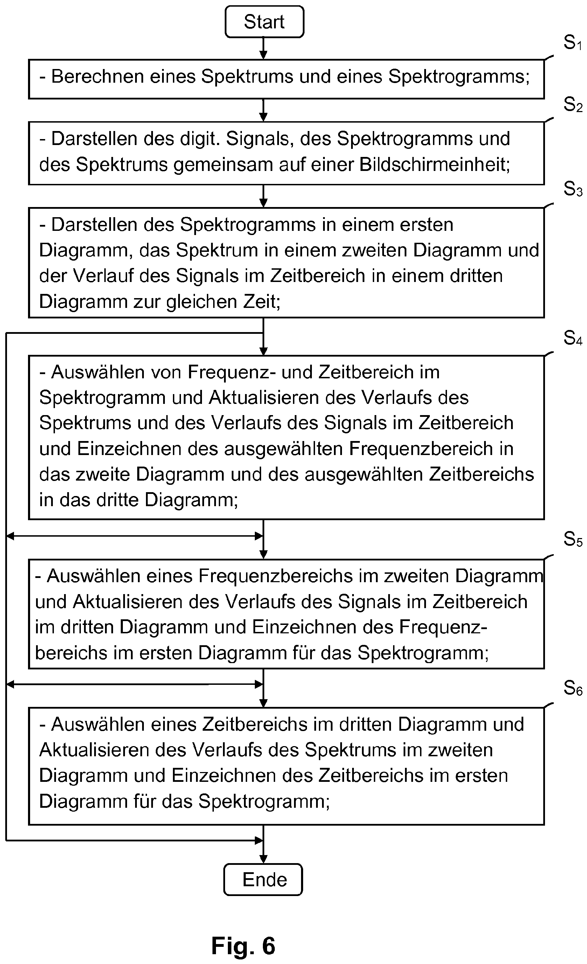

Fig. 6 zeigt ein Ausführungsbeispiel eines Flussdiagramms das die Funktionsweise der erfindungsgemäßen Anordnung 1 zur Signalanalyse näher beschreibt. Sobald das digitalisierte Signal 7 von einem Signalanalysator 8 oder einem Oszilloskop in die Anordnung 1 zur Signalanalyse geladen ist, kann der erste Verfahrensschritt S₁ ausgeführt werden. Innerhalb des ersten Verfahrensschritts berechnet die zumindest eine zentrale Datenverarbeitungseinheit 2 das Spektrum 31 und das Spektrogramm 30 des digitalisierten Signals 7. Dies geschieht mittels üblicher bekannter Methoden. Um diese Berechnung nicht ständig bei Änderung des Auswahlbereichs 36 zu wiederholen, ist es vorteilhaft, wenn die zumindest eine zentrale Datenverarbeitungseinheit 2 das in dem Frequenzbereich transformierte digitalisierte Signal 7 in einer Speichereinheit 3 speichert.

Im Anschluss daran wird der zweite Verfahrensschritt S₂ ausgeführt, in welchem die zumindest eine zentrale Datenverarbeitungseinheit 2 die Bildschirmeinheit 4 derart ansteuert, dass der Verlauf des Spektrums 31, des Spektrogramms 30 und der Verlauf 32 des im Zeitbereich vorliegenden digitalisierten Signals 7 gemeinsam auf der Bildschirmeinheit 4 dargestellt wird.

Im Anschluss daran kann der Verfahrensschritt S₃ ausgeführt werden. Innerhalb dieses Verfahrensschritts wird das Spektrogramm 30 des digitalisierten Signals 7 in einem ersten Diagramm 33 dargestellt. Der Verlauf des Spektrums 31 des digitalisierten Signals 7 wird in einem zweiten Diagramm 34 dargestellt und der Verlauf 32 des im Zeitbereich vorliegenden digitalisierten Signals 7 in einem dritten Diagramm 35. Die entsprechenden Signale werden in den Diagrammen 33, 34, 35 zur gleichen Zeit durch die zumindest eine zentrale Datenverarbeitungseinheit 2 auf der Bildschirmeinheit 4 dargestellt.

Im Weiteren kann der Verfahrensschritt S₄ ausgeführt werden. Innerhalb des Verfahrensschritts S₄ kann ein Frequenzbereich 39 und ein Zeitbereich 41 innerhalb des Spektrogramms 30 beliebig ausgewählt werden, wobei gleichzeitig in Abhängigkeit des ausgewählten Frequenzbereichs 39 und des Zeitbereichs 41 der Verlauf des Spektrums 31 und der zeitliche Verlauf 32 des digitalisierten Signals 7 durch die zumindest eine zentrale Datenverarbeitungseinheit 2 aktualisiert wird und wobei die aktualisierten Verläufe 31, 32 auf der Bildschirmeinheit 4 durch diese dargestellt wird. Im Weiteren ist es ebenfalls möglich, dass der im Spektrogramm 30 ausgewählte Frequenzbereich 39 in das zweite Diagramm 34 durch die zumindest eine zentrale Datenverarbeitungseinheit 2 eingezeichnet wird und dass der im Spektrogramm 30 ausgewählte Zeitbereich 41 in das dritte Diagramm 35 durch die zumindest eine zentrale Datenverarbeitungseinheit 2 eingezeichnet wird. Bei der beliebigen Auswahl des Frequenzbereichs 39 und des Zeitbereichs 41 handelt es sich auch um das beliebige Einstellen des Auswahlbereichs 36 im Sinne seiner Position und seinen Abmessungen innerhalb des Spektrogramms 30.

Nach dem Verfahrensschritt S₃ oder dem Verfahrensschritt S₄ kann der Verfahrensschritt S₅ ausgeführt werden. Innerhalb des Verfahrensschritts S₅ kann der Frequenzbereich 39 innerhalb des zweiten Diagramms 34 für den Verlauf des Spektrums 31 beliebig ausgewählt werden, wobei auf Grund des ausgewählten Frequenzbereichs 39 durch die zumindest eine zentrale Datenverarbeitungseinheit 2 der zeitliche Verlauf 32 des digitalisierten Signals 7 in dem dritten Diagramm 35 aktualisiert wird und/oder wobei der ausgewählte Frequenzbereich 39 in das erste Diagramm 33 für das Spektrogramm 30 durch die zumindest eine zentrale Datenverarbeitungseinheit 2 eingezeichnet wird, beziehungsweise der bereits vorhandene Auswahlbereich 36 entsprechend angepasst wird.

Im Anschluss an den Verfahrensschritt S₃, S₄ oder S₅ kann der Verfahrensschritt S₆ ausgeführt werden. Innerhalb des Verfahrensschritts S₆ kann der Zeitbereich 41 innerhalb des dritten Diagramms 35 für den zeitlichen Verlauf 32 des digitalisierten Signals 7 beliebig ausgewählt werden, wobei für den ausgewählten Zeitbereich 41 die zumindest eine zentrale Datenverarbeitungseinheit 2 den Verlauf des Spektrums 31 innerhalb des zweiten Diagramms 34 aktualisiert und/oder wobei die zumindest eine zentrale Datenverarbeitungseinheit 2 den ausgewählten Zeitbereich 41 in das erste Diagramm 33 für das Spektrogramm 30 einzeichnet, beziehungsweise den Auswahlbereich 36 entsprechend anpasst.

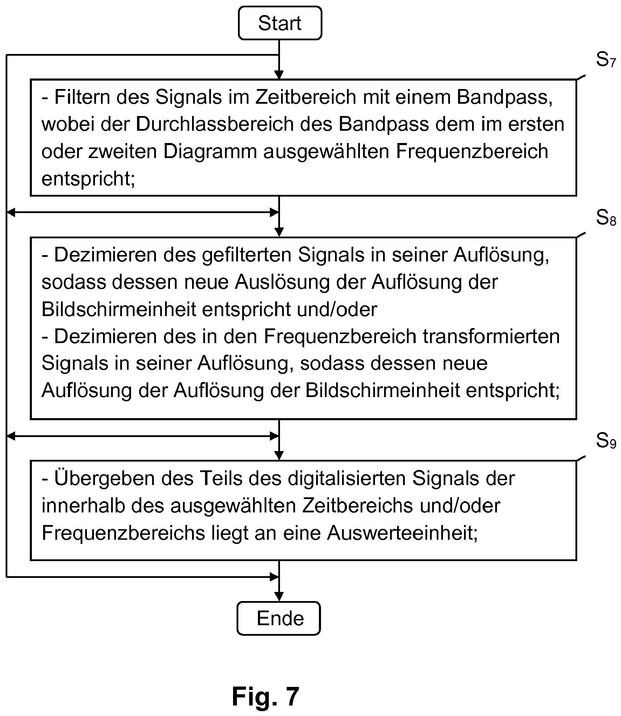

Schlussendlich zeigt Fig. 7 ein weitere Ausführungsbeispiel eines Flussdiagramms, das die Funktionsweise der erfindungsgemäßen Anordnung 1 zur Signalanalyse näher beschreibt. Im Weiteren wird der Verfahrensschritt S₇ ausgeführt, der bevorzugt aber nicht notwendigerweise vor dem Verfahrensschritt S₂ ausgeführt wird. Innerhalb des Verfahrensschritts S₇ wird das im Zeitbereich vorliegenden digitalisierte Signal 7 durch einen Bandpass 20 gefiltert, wobei der Durchlassbereich des Bandpass 20 den ausgewählten Frequenzbereich 39 des ersten Diagramms 33 für das Spektrogramm 30 oder dem ausgewählten Frequenzbereich 39 des zweiten Diagramms 34 für den Verlauf des Spektrums 31 entspricht. Da es sich bei diesem Bandpass 20 um ein digitales Filter handelt, können dessen Parameter besonders einfach an die aktuellen Einstellungen des Auswahlbereichs 36 angepasst werden. Ist noch kein Frequenzbereich 39 ausgewählt, so wird ein Standartfrequenzbereich eingestellt, der sich beispielsweise aus der Bandbreite des digitalisierten Signals 7 ergibt.

Nach dem Verfahrensschritt S₇ kann der Verfahrensschritt S₈ ausgeführt werden. Der Verfahrensschritt S₈ wird ebenfalls bevorzugt vor dem Verfahrensschritt S₂ ausgeführt. Innerhalb des Verfahrensschritts S₈ kann das gefilterte digitalisierte Signal 7 in seiner Auflösung durch eine erste Detektoreinheit 21 dezimiert werden, sodass das dezimierte digitalisierte Signal 7 einer Auflösung der Bildschirmeinheit 4 entspricht, wobei durch die erste Detektoreinheit 21 entweder der Mittelwert oder der quadratische Mittelwert oder der Maximalwert oder der Minimalwert oder der Auto-Peak-Wert von zumindest zwei Werten des digitalisierten Signals 7 berechnet wird. Es ist innerhalb des Verfahrensschritts S₈ ebenfalls möglich, dass das in den Frequenzbereich transformierte digitalisierte Signal 7 in seiner Auflösung durch eine zweite Detektoreinheit 24 dezimiert wird, sodass das dezimierte digitalisierte Signal 7 einer Auflösung der Bildschirmeinheit 4 entspricht, wobei durch die zweite Detektoreinheit 24 entweder der Mittelwert oder der quadratische Mittelwert oder der Maximalwert oder der Minimalwert oder der Auto-Peak-Wert von zumindest zwei Werten des digitalisierten Signals 7 berechnet wird.

Im Anschluss an den Verfahrensschritt S₇ oder den Verfahrensschritt S₈ kann der Verfahrensschritt S₉ ausgeführt werden. Der Verfahrensschritt S₉ wird allerdings bevorzugt nach dem Verfahrensschritt S₄, dem Verfahrensschritt S₅ oder dem Verfahrensschritt S₆ ausgeführt. Innerhalb des Verfahrensschritts S₉ wird der Teil des digitalisierten Signals 7, der innerhalb des ausgewählten Zeitbereichs 41 und/oder innerhalb des ausgewählten Frequenzbereichs 39 liegt durch die zumindest eine zentrale Datenverarbeitungseinheit 2 an eine Auswerteeinheit 6 übergeben. Bei dem Teil, der innerhalb des Auswahlbereichs 36, beziehungsweise innerhalb der vertikalen Begrenzungslinien 38₁, 38₂ oder 40₁, 40₂ liegt und an die Auswerteeinheit 6 übergeben wird, handelt es sich um den Teil des digitalisierten Signals 7, welcher noch nicht dezimiert ist. An die Auswerteeinheit 6 kann ein bestimmter Teil des Spektrums, des zeitlichen Verlaufs 32 des digitalisierten Signals 7 oder des Spektrogramms 30 übergeben werden.

Bei dem Filter, welcher als Bandpass 20 realisiert ist, handelt es sich bevorzugt um einen Raised-Cosine-Filter (dt. ansteigender Kosinus-Filter). Andere Filterarten können allerdings ebenfalls eingesetzt werden.

Im Rahmen der Erfindung sind alle beschriebenen und/oder gezeichneten Merkmale beliebig miteinander kombinierbar. Insbesondere können die Unteransprüche, das Verfahren betreffend, auch mit den Vorrichtungsansprüchen die Anordnung 1 zur Signalanalyse betreffend und umgekehrt kombiniert werden.

## Patentansprüche

1. Anordnung (1) zur Signalanalyse aufweisend zumindest eine zentrale Datenverarbeitungseinheit (2) und eine mit der zumindest einen zentralen Datenverarbeitungseinheit (2) verbundenen Bildschirmeinheit (4), wobei die zentrale Datenverarbeitungseinheit (2) aus einem digitalisierten Signal (7₁, 7₂; 7) ein Spektrum (31) und ein Spektrogramm (30) berechnet,
wobei die zumindest eine zentrale Datenverarbeitungseinheit (2) so ausgebildet ist, dass sie die Bildschirmeinheit (4) so ansteuert, dass das Spektrogramm (30) des digitalisierten Signals (7₁, 7₂; 7) in einem ersten Diagramm (33), der Verlauf des Spektrums (31) des digitalisierten Signals (7₁, 7₂; 7) in einem zweiten Diagramm (34) und der Verlauf (32) des im Zeitbereich vorliegenden digitalisierten Signals (7₁, 7₂; 7) in einem dritten Diagramm (35) gemeinsam auf der Bildschirmeinheit (4) zur gleichen Zeit darstellbar sind,
wobei durch die zumindest eine zentrale Datenverarbeitungseinheit (2) das digitalisierte Signal (7₁, 7₂; 7) in einer Speichereinheit (3) speicherbar ist; **dadurch gekennzeichnet, dass** die zumindest eine zentrale Datenverarbeitungseinheit (2) so ausgebildet ist, dass das im Zeitbereich (41) vorliegende digitalisierte Signal (7₁, 7₂; 7) durch einen Bandpass (20) filterbar ist,
wobei der Durchlassbereich des Bandpass (20) einem ausgewählten Frequenzbereich (39) des ersten Diagramms (33) für das Spektrogramm (30) oder einem ausgewählten Frequenzbereich (39) des zweiten Diagramms (34) für den Verlauf des Spektrums (31) entspricht, und
wobei das Spektrogramm (30) in einer Matrix (23) gespeichert ist.

2. Anordnung zur Signalanalyse nach Anspruch 1,
**dadurch gekennzeichnet,**
**dass** durch die zumindest eine zentrale Datenverarbeitungseinheit (2) das digitalisierte Signal (7₁, 7₂; 7) in den Frequenzbereich transformiert ist und in der Speichereinheit (3) speicherbar ist.

3. Anordnung zur Signalanalyse nach Anspruch 1,
**dadurch gekennzeichnet,**
**dass** ein Frequenz- (39) und Zeitbereich (41) innerhalb des Spektrogramms (30) beliebig auswählbar ist und dass durch die zumindest eine zentrale Datenverarbeitungseinheit (2) für den ausgewählten Frequenz- (39) und Zeitbereich (41) der Verlauf des Spektrums (31) und der zeitliche Verlauf (32) des digitalisierten Signals (7₁, 7₂; 7) aktualisierbar sind und auf der Bildschirmeinheit (4) darstellbar sind und/oder
**dass** durch die zumindest eine zentrale Datenverarbeitungseinheit (2) der im Spektrogramm (30) ausgewählte Frequenzbereich (39) in das zweite Diagramm (34) einzeichenbar ist und/oder
**dass** durch die zumindest eine zentrale Datenverarbeitungseinheit (2) der im Spektrogramm (30) ausgewählte Zeitbereich (41) in das dritte Diagramm (35) einzeichenbar ist.

4. Anordnung zur Signalanalyse nach Anspruch 1 oder 3, **dadurch gekennzeichnet,**
**dass** ein Frequenzbereich (39) innerhalb des zweiten Diagramms (34) für den Verlauf des Spektrums (31) beliebig auswählbar ist und dass durch die zumindest eine zentrale Datenverarbeitungseinheit (2) der zeitliche Verlauf (32) des digitalisierten Signals (7₁, 7₂; 7) auf Grund des ausgewählten Frequenzbereichs (39) aktualisierbar ist und/oder
**dass** durch die zumindest eine zentrale Datenverarbeitungseinheit (2) der im zweiten Diagramm (34) ausgewählte Frequenzbereich (39) in das erste Diagramm (33) für das Spektrogramm (30) einzeichenbar ist.

5. Anordnung zur Signalanalyse nach einem der Ansprüche 1 bis 4,
**dadurch gekennzeichnet,**
**dass** ein Zeitbereich (41) innerhalb des dritten Diagramms (35) für den zeitlichen Verlauf (32) des digitalisierten Signals (7₁, 7₂; 7) beliebig auswählbar ist und dass durch die zumindest eine zentrale Datenverarbeitungseinheit (2) der Verlauf des Spektrums (31) auf Grund des ausgewählten Zeitbereichs (41) aktualisierbar ist und/oder
**dass** durch die zumindest eine zentrale Datenverarbeitungseinheit (2) der im dritten Diagramm (35) ausgewählte Zeitbereich (41) in das erste Diagramm (33) für das Spektrogramm (30) einzeichenbar ist.

6. Anordnung zur Signalanalyse nach einem der Ansprüche 1 bis 5,
**dadurch gekennzeichnet,**
**dass** das gefilterte digitalisierte Signal (7₁, 7₂; 7) durch eine erste Detektoreinheit (21) in seiner Auflösung dezimierbar ist, sodass das dezimierte digitalisierte Signal (7₁, 7₂; 7) einer Auflösung der Bildschirmeinheit (4) entspricht, wobei durch die erste Detektoreinheit (21) entweder der Mittelwert oder der quadratischen Mittelwert oder der Maximalwert oder der Minimalwert oder der Auto-Peak-Wert von zumindest zwei Werten des digitalisierten Signals (7₁, 7₂; 7) berechenbar ist und/oder
**dass** durch eine zweite Detektoreinheit (24) das in den Frequenzbereich transformierte digitalisierte Signal (7₁, 7₂; 7) in seiner Auflösung dezimierbar ist, sodass das dezimierte digitalisierte Signal (7₁, 7₂; 7) einer Auflösung der Bildschirmeinheit (4) entspricht, wobei durch die zweite Detektoreinheit (24) entweder der Mittelwert oder der quadratischen Mittelwert oder der Maximalwert oder der Minimalwert oder der Auto-Peak-Wert von zumindest zwei Werten des digitalisierten Signals (7₁, 7₂; 7) berechenbar ist.

7. Anordnung zur Signalanalyse nach einem der Ansprüche 1 bis 6,
**dadurch gekennzeichnet,**
**dass** der Teil des digitalisierten Signals (7₁, 7₂; 7) der innerhalb des ausgewählten Zeitbereichs (41) und/oder Frequenzbereichs (39) liegt, durch die zumindest eine zentrale Datenverarbeitungseinheit (2) an eine Auswerteeinheit (6) übergebbar ist.

8. Verfahren zum Betrieb einer Anordnung (1) zur Signalanalyse aufweisend zumindest eine zentrale Datenverarbeitungseinheit (2) und eine mit der zumindest einen zentralen Datenverarbeitungseinheit (2) verbundene Bildschirmeinheit (4),
mit den Verfahrensschritten:
- Berechnen (S₁) eines Spektrums (31) und eines Spektrogramms (30) aus einem digitalisierten Signal (7₁, 7₂; 7) durch die zentrale Datenverarbeitungseinheit (2),
- Darstellen (S₂) des Spektrogramms (30) des digitalisierten Signals (7₁, 7₂; 7) in einem ersten Diagramm (33), des Verlaufs des Spektrums (31) des digitalisierten Signals (7₁, 7₂; 7) in einem zweiten Diagramm (34) und des Verlaufs (32) des im Zeitbereich vorliegenden digitalisierten Signals (7₁, 7₂; 7) in einem dritten Diagramm (35) gemeinsam auf der Bildschirmeinheit (4) zur gleichen Zeit durch die zumindest eine zentrale Datenverarbeitungseinheit (2)
- Speichern des digitalisierten Signals (7₂, 7₂; 7) durch die zumindest eine zentrale Datenverarbeitungseinheit (2) in einer Speichereinheit (3); durch die folgenden Verfahrensschritte gekennzeichnet:
- Filtern (S₇) des im Zeitbereich vorliegenden digitalisierten Signals (7₁, 7₂; 7) durch einen Bandpass (20), wobei der Durchlassbereich des Bandpass (20) einem ausgewählten Frequenzbereich (39) des ersten Diagramms (33) für das Spektrogramm (30) oder einem ausgewählten Frequenzbereich (39) des zweiten Diagramms (34) für den Verlauf des Spektrums (31) entspricht, und
- Speichern des Spektrogramms (30) durch die zumindest eine zentrale Datenverarbeitungseinheit (2) in einer Matrix (23).

9. Verfahren nach Anspruch 8,
**gekennzeichnet durch,**
folgende weitere Verfahrensschritte:
- Beliebiges Auswählen (S₄) eines Frequenz- (39) und Zeitbereichs (41) innerhalb des Spektrogramms (30) und
Aktualisieren des Verlaufs des Spektrums (31) und des zeitlichen Verlaufs (32) des digitalisierten Signals (7₁, 7₂; 7) **durch** die zumindest eine zentrale Datenverarbeitungseinheit (2) für den ausgewählten Frequenz- (39) und Zeitbereich (41) und Darstellen dieser aktualisierten Verläufe (31,32) auf der Bildschirmeinheit (4) und/oder Einzeichnen des im Spektrogramms (30) ausgewählten Frequenzbereichs (39) in das zweite Diagramm (34) durch die zumindest eine zentrale Datenverarbeitungseinheit (2) und
Einzeichnen des im Spektrogramms (30) ausgewählten Zeitbereichs (41) in das dritte Diagramm (35) **durch** die zumindest eine zentrale Datenverarbeitungseinheit (2) .

10. Verfahren nach Anspruch 8 oder 9,
**gekennzeichnet durch,**
folgende weitere Verfahrensschritte:
- Beliebiges Auswählen (S₅) eines Frequenzbereichs (39) innerhalb des zweiten Diagramms (34) für den Verlauf des Spektrums (31) und
Aktualisieren des zeitlichen Verlaufs (32) des digitalisierten Signals (7₁, 7₂; 7) auf Grund des ausgewählten Frequenzbereichs (39) **durch** die zumindest eine zentrale Datenverarbeitungseinheit (2) und/oder
Einzeichnen des im zweiten Diagramm (34) ausgewählten Frequenzbereichs (39) in das erste Diagramm (33) für das Spektrogramm (30) **durch** die zumindest eine zentrale Datenverarbeitungseinheit (2).

11. Verfahren nach einem der Ansprüche 8 bis 10,
**gekennzeichnet durch,**
folgende weitere Verfahrensschritte:
- Beliebiges Auswählen (S₆) eines Zeitbereichs (41) innerhalb des dritten Diagramms (35) für den zeitlichen Verlauf (32) des digitalisierten Signals (7₁, 7₂; 7) und
Aktualisieren des Verlaufs des Spektrums (31) auf Grund des ausgewählten Zeitbereichs (41) **durch** die zumindest eine zentrale Datenverarbeitungseinheit (2) und/oder
Einzeichnen des im dritten Diagramm (35) ausgewählten Zeitbereichs (41) in das erste Diagramm (33) für das Spektrogramm (30) **durch** die zumindest eine zentrale Datenverarbeitungseinheit (2).

12. Verfahren nach einem der Ansprüche 8 bis 11,
**gekennzeichnet durch,**
folgende weitere Verfahrensschritte:
- Dezimieren (S₈) des gefilterten digitalisierten Signals (7₁, 7₂; 7) in seiner Auflösung **durch** eine erste Detektoreinheit (21), sodass das dezimierte digitalisierte Signal (7₁, 7₂; 7) einer Auflösung der Bildschirmeinheit (4) entspricht, wobei **durch** die erste Detektoreinheit (21) entweder der Mittelwert oder der quadratischen Mittelwert oder der Maximalwert oder der Minimalwert oder der Auto-Peak-Wert von zumindest zwei Werten des digitalisierten Signals (7₁, 7₂; 7) berechnet wird und/oder
- Dezimieren (S₈) des in den Frequenzbereich transformierten digitalisierten Signals (7₁, 7₂; 7) in seiner Auflösung **durch** eine zweite Detektoreinheit (24), sodass das dezimierte digitalisierte Signal (7₁, 7₂; 7) einer Auflösung der Bildschirmeinheit (4) entspricht, wobei **durch** die zweite Detektoreinheit (24) entweder der Mittelwert oder der quadratischen Mittelwert oder der Maximalwert oder der Minimalwert oder der Auto-Peak-Wert von zumindest zwei Werten des digitalisierten Signals (7₁, 7₂; 7) berechnet wird.

13. Verfahren nach einem der Ansprüche 8 bis 1216,
**gekennzeichnet durch,**
folgenden weiteren Verfahrensschritt:
- Übergeben (S₉) des Teils des digitalisierten Signals (7₁, 7₂; 7), der innerhalb des ausgewählten Zeitbereichs (41) und/oder Frequenzbereichs (39) liegt, **durch** die zumindest eine zentrale Datenverarbeitungseinheit (2) an eine Auswerteeinheit (6) .

14. Computerprogramm mit Programmcode-Mitteln, um alle Schritte gemäß einem der Ansprüche 8 bis 13 durchführen zu können, wenn das Programm auf einem Computer oder einem digitalen Signalprozessor ausgeführt wird.

15. Computerprogramm-Produkt mit insbesondere auf einem maschinenlesbaren Träger gespeicherten Programmcode-Mitteln, um alle Schritte gemäß einem der Ansprüche 8 bis 13 durchführen zu können, wenn das Programm auf einem Computer oder einem digitalen Signalprozessor ausgeführt wird.

## Claims

1. Arrangement (1) for signal analysis having at least one central data processing unit (2) and a screen unit (4) connected with the at least one central data processing unit (2), wherein the central data processing unit (2) calculates a spectrum (31) and a spectrogram (30) from a digitized signal (7₁, 7₂; 7),
wherein the at least one central data processing unit (2) is configured so that it controls the screen unit (4) in such a way that in a first diagram (33) the spectrogram (30) of the digitized signal (7₁, 7₂; 7), in a second diagram (34) the characteristic of the spectrum (31) of the digitized signal (7₁, 7₂; 7) and in a third diagram (35) the characteristic (32) of the digitized signal (7₁, 7₂; 7) present in the time domain can be displayed together and at the same time on the screen unit (4),
wherein the digitized signal (7₁, 7₂; 7) can be stored in a memory unit (3) by the at least one central data processing unit (2),
**characterized in that** the at least one central data processing unit (2) is configured so that the digitized signal (7₁, 7₂; 7) present in the time domain (41) can be filtered through a band pass filter (20),
wherein the band pass range of the band pass filter (20) corresponds to a selected frequency range (39) of the first diagram (33) for the spectrogram (30) or a selected frequency range (39) of the second diagram (34) for the characteristic of the spectrum (31), and
wherein the spectrogram (30) is stored in a matrix (23).

2. The arrangement for signal analysis according to claim 1,
**characterized**
**in that** the digitized signal (7₁, 7₂; 7) is transformed into the frequency domain and can be stored in the memory unit (3) by the at least one central data processing unit (2).

3. The arrangement for signal analysis according to claim 1,
**characterized**
**in that** a frequency range (39) and time range (41) can be selected optionally within the spectrogram (30) and in that the characteristic of the spectrum (31) and the characteristic over time (32) of the digitized signal (7₁, 7₂; 7) can be updated for the selected frequency range (39) and time range (41) by the at least one central data processing unit (2) and displayed on the screen unit (4), and/or
**in that** the frequency range (39) selected in the spectrogram (30) can be plotted into the second diagram (34) by the at least one central data processing unit (2) and/or
**in that** the time range (41) selected in the spectrogram (30) can be plotted into the third diagram (35) by the at least one central data processing unit (2).

4. The arrangement for signal analysis according to claim 1 or 3,
**characterized**
**in that** a frequency range (39) can be selected optionally within the second diagram (34) for the characteristic of the spectrum (31) and in that the characteristic over time (32) of the digitized signal (7₁, 7₂; 7) can be updated on the basis of the selected frequency range (39) by the at least one central data processing unit (2) and/or
**in that** the frequency range (39) selected in the second diagram (34) can be plotted into the first diagram (33) for the spectrogram (30) by the at least one central data processing unit (2).

5. The arrangement for signal analysis according to any of claims 1 to 4,
**characterized**
**in that** a time range (41) can be selected optionally within the third diagram (35) for the characteristic over time (32) of the digitized signal (7₁, 7₂; 7) and in that the characteristic of the spectrum (31) can be updated on the basis of the selected time range (41) by the at least one central data processing unit (2) and/or
**in that** the time range (41) selected in the third diagram (35) can be plotted into the first diagram (33) for the spectrogram (30) by the at least one central data processing unit (2).

6. The arrangement for signal analysis according to any of claims 1 to 5,
**characterized**
**in that** the filtered digitized signal (7₁, 7₂; 7) can be decimated in its resolution by a first detector unit (21) so that the decimated digitized signal (7₁, 7₂; 7) corresponds to a resolution of the screen unit (4), wherein either the mean value or the mean squared value or the maximum value or the minimum value or the auto peak value of at least two values of the digitized signal (7₁, 7₂; 7) can be calculated by the first detector unit (21) and/or
**in that** the digitized signal (7₁, 7₂; 7) transformed into the frequency domain is decimated in its resolution by a second detector unit (24) so that the decimated digitized signal (7₁, 7₂; 7) corresponds to a resolution of the screen unit (4), wherein either the mean value or the mean squared value or the maximum value or the minimum value or the auto peak value of at least two values of the digitized signal (7₁, 7₂; 7) can be calculated by the second detector unit (24).

7. The arrangement for signal analysis according to any of claims 1 to 6,
**characterized**
**in that** the part of the digitized signal (7₁, 7₂; 7) which lies within the selected time range (41) and/or frequency range (39) can be passed over to an evaluation unit (6) by the at least one central data processing unit (2).

8. A method for operating an arrangement (1) for signal analysis having at least one central data processing unit (2) and a screen unit (4) connected with the at least one central data processing unit (2),
with the method steps:
- calculating (S₁) of a spectrum (31) and of a spectrogram (30) from a digitized signal (7₁, 7₂; 7) by the central data processing unit (2),
- displaying (S₂) of the spectrogram (30) of the digitized signal (7₁, 7₂; 7) in a first diagram (33), of the characteristic of the spectrum (31) of the digitized signal (7₁, 7₂; 7) in a second diagram (34), and of the characteristic (32) of the digitized signal (7₁, 7₂; 7) present in the time domain in a third diagram (35) together and at the same time on the screen unit (4) by the at least one central data processing unit (2) and
- storage of the digitized signal (7₁, 7₂; 7) in a memory unit (3) by the at least one central data processing unit (2), **characterized by** the following method steps:
- filtering (S₇) of the digitized signal (7₁, 7₂; 7) present in the time domain through a band pass filter (20), wherein the band pass range of the band pass filter (20) corresponds to a selected frequency range (39) of the first diagram (33) for the spectrogram (30) or a selected frequency range (39) of the second diagram (34) for the characteristic of the spectrum (31), and
- storage of the spectrogram (30) by the at least one central data processing unit (2) in a matrix (23).

9. The method according to claim 8,
**characterized by**
the following further method steps:
- optional selecting (S₄) of a frequency range (39) and time range (41) within the spectrogram (30) and
- updating of the characteristic of the spectrum (31) and the characteristic over time (32) of the digitized signal (7₁, 7₂; 7) by the at least one central data processing unit (2) for the selected frequency range (39) and time range (41) and
- displaying of these updated characteristics (31, 32) on the screen unit (4) and/or
- plotting of the frequency range (39) selected in the spectrogram (30) into the second diagram (34) by the at least one central data processing unit (2) and
- plotting of the time range (41) selected in the spectrogram (30) into the third diagram (35) by the at least one central data processing unit (2).

10. The method according to claim 8 or 9,
**characterized by**
the following further method steps:
- optional selecting (S₅) of a frequency range (39) within the second diagram (34) for the characteristic of the spectrum (31) and
- updating of the characteristic over time (32) of the digitized signal (7₁, 7₂; 7) on the basis of the selected frequency range (39) by the at least one central data processing unit (2) and/or
- plotting of the frequency range (39) selected in the second diagram (34) into the first diagram (33) for the spectrogram (30) by the at least one central data processing unit (2).

11. The method according to any of claims 8 to 10,
**characterized by**
the following further method steps:
- optional selecting (S₆) of a time range (41) within the third diagram (35) for the characteristic over time (32) of the digitized signal (7₁, 7₂; 7) and
- updating of the characteristic of the spectrum (31) on the basis of the selected time range (41) by the at least one central data processing unit (2) and/or
- plotting of the time range (41) selected in the third diagram (35) into the first diagram (33) for the spectrogram (30) by the at least one central data processing unit (2).

12. The method according to any of claims 8 to 11,
**characterized by**
the following further method steps:
- decimating (S₈) of the filtered digitized signal (7₁, 7₂; 7) in its resolution by a first detector unit (21) so that the decimated digitized signal (7₁, 7₂; 7) corresponds to a resolution of the screen unit (4), wherein either the mean value or the mean squared value or the maximum value or the minimum value or the auto peak value of at least two values of the digitized signal (7₁, 7₂; 7) is calculated by the first detector unit (21) and/or
- decimating (S₈) of the digitized signal (7₁; 7₂; 7) transformed into the frequency domain in its resolution by a second detector unit (24) so that the decimated digitized signal (7₁, 7₂; 7) corresponds to a resolution of the screen unit (4), wherein either the mean value or the mean squared value or the maximum value or the minimum value or the auto peak value of at least two values of the digitized signal (7₁, 7₂; 7) is calculated by the second detector unit (24).

13. The method according to any of claims 8 to 12,
**characterized by**
the following further method step:
- passing over (Sg) of the part of the digitized signal (7₁, 7₂; 7) which lies within the selected time range (41) and/or frequency range (39) by the at least one central data processing unit (2) to an evaluation unit (6).

14. A computer program with program code means in order to be able to carry out all the steps according to any of claims 8 to 13 when the program is implemented on a computer or a digital signal processor.

15. A computer program product with in particular program code means stored on a machine-readable data medium in order to be able to carry out all the steps according to any of claims 8 to 13 when the program is implemented on a computer or a digital signal processor.

## Revendications

1. Dispositif (1) d'analyse de signaux, comprenant au moins une unité centrale de traitement de données (2) et une unité d'écran (4) reliée à ladite au moins une unité centrale de traitement de données (2),
où l'unité centrale de traitement de données (2) calcule un spectre (31) et un spectrogramme (30) à partir d'un signal numérisé (7₁, 7₂ ; 7),
où ladite au moins une unité centrale de traitement de données (2) est conçue de manière à commander l'unité d'écran (4) pour que le spectrogramme (30) du signal numérisé (7₁, 7₂; 7) soit représentable dans un premier diagramme (33), la courbe du spectre (31) du signal numérisé (7₁, 7₂ ; 7) soit représentable dans un deuxième diagramme (34) et la courbe (32) du signal numérisé (7₁, 7₂ ; 7) présenté dans la plage temporelle soit représentable dans un troisième diagramme (35), ensemble et simultanément sur l'unité d'écran (4),
où le signal numérisé (7₁, 7₂ ; 7) est mémorisable dans une unité de mémoire (3) par ladite au moins une unité centrale de traitement de données (2) ;
**caractérisé en ce que** ladite au moins une unité centrale de traitement de données (2) est conçue de sorte que le signal numérisé (7₁, 7₂ ; 7) présenté dans la plage temporelle (41) soit filtrable par un filtre passe-bande (20),
où la plage de transmission du filtre passe-bande (20) correspond à une plage de fréquence (39) sélectionnée du premier diagramme (33) pour le spectrogramme (30) ou à une plage de fréquence (39) sélectionnée du second diagramme (34) pour la courbe du spectre (31), et
où le spectrogramme (30) est mémorisé dans une matrice (23).

2. Dispositif d'analyse de signaux selon la revendication 1,
**caractérisé en ce que**
le signal numérisé (7₁, 7₂ ; 7) est transformé dans la plage de fréquence et est mémorisable dans l'unité de mémoire (3) par ladite au moins une unité centrale de traitement de données (2).

3. Dispositif d'analyse de signaux selon la revendication 1,
**caractérisé en ce que**
une plage de fréquence (39) et une plage temporelle (41) sont librement sélectionnables à l'intérieur du spectrogramme (30) et **en ce que** la courbe du spectre (31) et la courbe temporelle (32) du signal numérisé (7₁, 7₂ ; 7) sont actualisables et représentables sur l'unité d'écran (4) par ladite au moins une unité centrale de traitement de données (2) pour la plage de fréquence (39) et la plage temporelle (41) sélectionnées, et/ou **en ce que**
la plage de fréquence (39) sélectionnée dans le spectrogramme (30) est figurable dans le deuxième diagramme (34) par ladite au moins une unité centrale de traitement de données (2), et/ou **en ce que**
la plage temporelle (41) sélectionnée dans le spectrogramme (30) est figurable dans le troisième diagramme (35) par ladite au moins une unité centrale de traitement de données (2).

4. Dispositif d'analyse de signaux selon la revendication 1 ou 3,
**caractérisé en ce que**
une plage de fréquence (39) est librement sélectionnable à l'intérieur du deuxième diagramme (34) pour la courbe du spectre (31), et **en ce que**
la courbe temporelle (32) du signal numérisé (7₁, 7₂ ; 7) est actualisable sur la base de la plage de fréquence (39) sélectionnée par ladite au moins une unité centrale de traitement de données (2), et/ou **en ce que**
la plage de fréquence (39) sélectionnée dans le deuxième diagramme (34) est figurable dans le premier diagramme (33) pour le spectrogramme (30) par ladite au moins une unité centrale de traitement de données (2).

5. Dispositif d'analyse de signaux selon l'une des revendications 1 à 4,
**caractérisé en ce qu'**une plage temporelle (41) est librement sélectionnable à l'intérieur du troisième diagramme (35) pour la courbe temporelle (32) du signal numérisé (7₁, 7₂ ; 7), et **en ce que**
la courbe du spectre (31) est actualisable sur la base de la plage temporelle (41) sélectionnée par ladite au moins une unité centrale de traitement de données (2), et/ou **en ce que**
la plage temporelle (41) sélectionnée dans le troisième diagramme (35) est figurable dans le premier diagramme (33) pour le spectrogramme (30) par ladite au moins une unité centrale de traitement de données (2).

6. Dispositif d'analyse de signaux selon l'une des revendications 1 à 5,
**caractérisé en ce que**
le signal numérisé filtré (7₁, 7₂ ; 7) est décimable dans sa résolution par une première unité de détection (21) de sorte que le signal numérisé décimé (7₁, 7₂ ; 7) corresponde à une résolution de l'unité d'écran (4), où la moyenne ou la moyenne quadratique ou la valeur maximale ou la valeur minimale ou la valeur de crête automatique d'au moins deux valeurs du signal numérisé (7₁, 7₂ ; 7) sont calculables par la première unité de détection (21) et/ou **en ce que**
le signal numérisé (7₁, 7₂ ; 7) transformé dans la plage de fréquence est décimable dans sa résolution par une deuxième unité de détection (24) de sorte que le signal numérisé décimé (7₁, 7₂ ; 7) corresponde à une résolution de l'unité d'écran (4), où la moyenne ou la moyenne quadratique ou la valeur maximale ou la valeur minimale ou la valeur de crête automatique d'au moins deux valeurs du signal numérisé (7₁, 7₂ ; 7) est calculable par l'unité de détection (24).

7. Dispositif d'analyse de signaux selon l'une des revendications 1 à 6,
**caractérisé en ce que**
la part du signal numérisé (7₁, 7₂ ; 7) présentée à l'intérieur de la plage temporelle (41) et/ou de la plage de fréquence (39) sélectionnée est transférable à une unité d'analyse (6) par ladite au moins une unité centrale de traitement de données (2).

8. Procédé de fonctionnement d'un dispositif (1) d'analyse de signaux comprenant au moins une unité centrale de traitement de données (2) et une unité d'écran (4) reliée à ladite au moins une unité centrale de traitement de données (2),
comprenant les étapes de procédé suivantes :
- calcul (S₁) d'un spectre (31) et d'un spectrogramme (30) à partir d'un signal numérisé (7₁, 7₂ ; 7) par ladite unité centrale de traitement de données (2),
- représentation (S₂) du spectrogramme (30) du signal numérisé (7₁, 7₂ ; 7) dans un premier diagramme (33), de la courbe du spectre (31) du signal numérisé (7₁, 7₂ ; 7) dans un deuxième diagramme (34), et de la courbe (32) du signal numérisé (7₁, 7₂ ; 7) présenté dans la plage temporelle dans un troisième diagramme (35), ensemble et simultanément sur l'unité d'écran (4) par ladite au moins une unité centrale de traitement de données (2),
- mémorisation du signal numérisé (7₁, 7₂ ; 7) dans une unité de mémoire (3) par ladite au moins une unité centrale de traitement de données (2) ; **caractérisé par** les étapes de procédé suivantes :
- filtrage (S₇) du signal numérisé (7₁, 7₂ ; 7) présenté dans la plage temporelle par un filtre passe-bande (20), où la plage de transmission du filtre passe-bande (20) correspond à une plage de fréquence (39) sélectionnée du premier diagramme (33) pour le spectrogramme (30) ou à une plage de fréquence (39) sélectionnée du second diagramme (34) pour la courbe du spectre (31),
- mémorisation du spectrogramme (30) dans une matrice (23) par ladite au moins une unité centrale de traitement de données (2).

9. Procédé selon la revendication 8,
**caractérisé par**
les autres étapes de procédé suivantes :
- libre sélection (S₄) d'une plage de fréquence (39) et d'une plage temporelle (41) à l'intérieur du spectrogramme (30), et
- actualisation de la courbe du spectre (31) et de la courbe temporelle (32) du signal numérisé (7₁, 7₂ ; 7) par ladite au moins une unité centrale de traitement de données (2) pour la plage de fréquence (39) et la plage temporelle (41) sélectionnées, et
- représentation de ces courbes actualisées (31, 32) sur l'unité d'écran (4) et/ou
- figuration de la plage de fréquence (39) sélectionnée dans le spectrogramme (30) dans le deuxième diagramme (34) par ladite au moins une unité centrale de traitement de données (2), et
- figuration de la plage temporelle (41) sélectionnée dans le spectrogramme (30) dans le troisième diagramme (35) par ladite au moins une unité centrale de traitement de données (2).

10. Procédé selon la revendication 8 ou 9,
**caractérisé par**
les autres étapes de procédé suivantes :
- libre sélection (S₅) d'une plage de fréquence (39) à l'intérieur du deuxième diagramme (34) pour la courbe du spectre (31), et
- actualisation de la courbe temporelle (32) du signal numérisé (7₁, 7₂ ; 7) sur la base de la plage de fréquence (39) sélectionnée par ladite au moins une unité centrale de traitement de données (2), et/ou
- figuration de la plage de fréquence (39) sélectionnée dans le deuxième diagramme (34) dans le premier diagramme (33) pour le spectrogramme (30) par ladite au moins une unité centrale de traitement de données (2).

11. Procédé selon l'une des revendications 8 à 10, **caractérisé par**
les autres étapes de procédé suivantes :
- libre sélection (S₆) d'une plage temporelle (41) à l'intérieur du troisième diagramme (35) pour la courbe temporelle (32) du signal numérisé (7₁, 7₂ ; 7), et
- actualisation de la courbe du spectre (31) sur la base de la plage temporelle (41) sélectionnée par ladite au moins une unité centrale de traitement de données (2), et/ou
- figuration de la plage temporelle (41) sélectionnée dans le troisième diagramme (35) dans le premier diagramme (33) pour le spectrogramme (30) par ladite au moins une unité centrale de traitement de données (2).

12. Procédé selon l'une des revendications 8 à 11, **caractérisé par**
les autres étapes de procédé suivantes :
- décimation (S₈) dans sa résolution du signal numérisé filtré (7₁, 7₂ ; 7) par une première unité de détection (21), de sorte que le signal numérisé décimé (7₁, 7₂ ; 7) corresponde à une résolution de l'unité d'écran (4), où la moyenne ou la moyenne quadratique ou la valeur maximale ou la valeur minimale ou la valeur de crête automatique d'au moins deux valeurs du signal numérisé (7₁, 7₂ ; 7) est calculée par la première unité de détection (21), et/ou
- décimation (S₈) dans sa résolution du signal numérisé (7₁, 7₂ ; 7) transformé dans la plage de fréquence par une deuxième unité de détection (24) de sorte que le signal numérisé décimé (7₁, 7₂ ; 7) corresponde à une résolution de l'unité d'écran (4), où la moyenne ou la moyenne quadratique ou la valeur maximale ou la valeur minimale ou la valeur de crête automatique d'au moins deux valeurs du signal numérisé (7₁, 7₂ ; 7) est calculée par la deuxième unité de détection (24).

13. Procédé selon l'une des revendications 8 à 12,
**caractérisé par**
l'autre étape de procédé suivante :
- transfert (S₉) à une unité d'analyse (6) de la part du signal numérisé (7₁, 7₂ ; 7) présentée à l'intérieur de la plage temporelle (41) et/ou de la plage de fréquence (39) sélectionnée par ladite au moins une unité centrale de traitement de données (2).

14. Programme informatique avec des moyens de code-programme pour pouvoir exécuter toutes les étapes selon l'une des revendications 8 à 13, quand le programme est lancé sur un ordinateur ou un processeur numérique de signaux.

15. Produit de programme informatique avec des moyens de code-programme mémorisés en particulier sur un support lisible par machine pour pouvoir exécuter toutes les étapes selon l'une des revendications 8 à 13, quand le programme est lancé sur un ordinateur ou un processeur numérique de signaux.
